# EUROPEAN PATENT SPECIFICATION

(11) **EP 2 250 650 B1**
(45) Date of publication and mention of the grant of the patent: **10.08.2011**
(21) Application number: 09720025.7
(22) Date of filing: 11.03.2009
(51) Int. Cl.: H01B 1/22

(54) **ALUMINUM PASTES AND USE THEREOF IN THE PRODUCTION OF SILICON SOLAR CELLS**
ALUMINIUMPASTEN UND IHRE VERWENDUNG BEI DER HERSTELLUNG VON SILICIUM-SOLARZELLEN
PÂTES D ALUMINIUM ET UTILISATION DE CES PÂTES POUR LA PRODUCTION DE CELLULES SOLAIRES AU SILICIUM

(30) Priority: 13.03.2008 US 36208
(43) Date of publication of application: 17.11.2010
(73) Proprietor: E. I. du Pont de Nemours and Company, Wilmington, DE 19898 (US)
(72) Inventor: YOUNG, Richard, John Sheffield, Bath BA26NE (GB); ROSE, Michael, South Gloucestershire BS37 7UF (GB); PRINCE, Alistair, Graeme, Bristol BS3 3JW (GB)
(74) Representative: DuPont Performance Coatings Biering/Blum/Kimpel
(86) International application number: PCT/US2009/036738
(87) International publication number: WO 2009/114584

(56) References cited:
- EP-A- 1 087 646
- EP-A- 1 713 092
- EP-A- 1 732 136
- EP-A- 1 732 137
- EP-A1- 2 263 240
- EP-A1- 2 263 240
- WO-A1-2009/129092
- WO-A1-2009/129092
- WO-A1-2010/028325
- WO-A1-2010/028325
- GB-A- 2 428 689

## Description

### FIELD OF THE INVENTION

The present invention is directed to aluminum pastes, and their use in the production of silicon solar cells, i.e., in the production of aluminum back electrodes of silicon solar cells and the respective silicon solar cells.

### TECHNICAL BACKGROUND OF THE INVENTION

A conventional solar cell structure with a p-type base has a negative electrode that is typically on the front-side or sun side of the cell and a positive electrode on the back-side. It is well known that radiation of an appropriate wavelength falling on a p-n junction of a semiconductor body serves as a source of external energy to generate hole-electron pairs in that body. The potential difference that exists at a p-n junction, causes holes and electrons to move across the junction in opposite directions and thereby give rise to flow of an electric current that is capable of delivering power to an external circuit. Most solar cells are in the form of a silicon wafer that has been metalized, i.e., provided with metal contacts which are electrically conductive.

During the formation of a silicon solar cell, an aluminum paste is generally screen printed and dried on the back-side of the silicon wafer. The wafer is then fired at a temperature above the melting point of aluminum to form an aluminum-silicon melt, subsequently, during the cooling phase, a epitaxially grown layer of silicon is formed that is doped with aluminum. This layer is generally called the back surface field (BSF) layer, and helps to improve the energy conversion efficiency of the solar cell.

Most electric power-generating solar cells currently used are silicon solar cells. Process flow in mass production is generally aimed at achieving maximum simplification and minimizing manufacturing costs. Electrodes in particular are made by using a method such as screen printing from a metal paste.

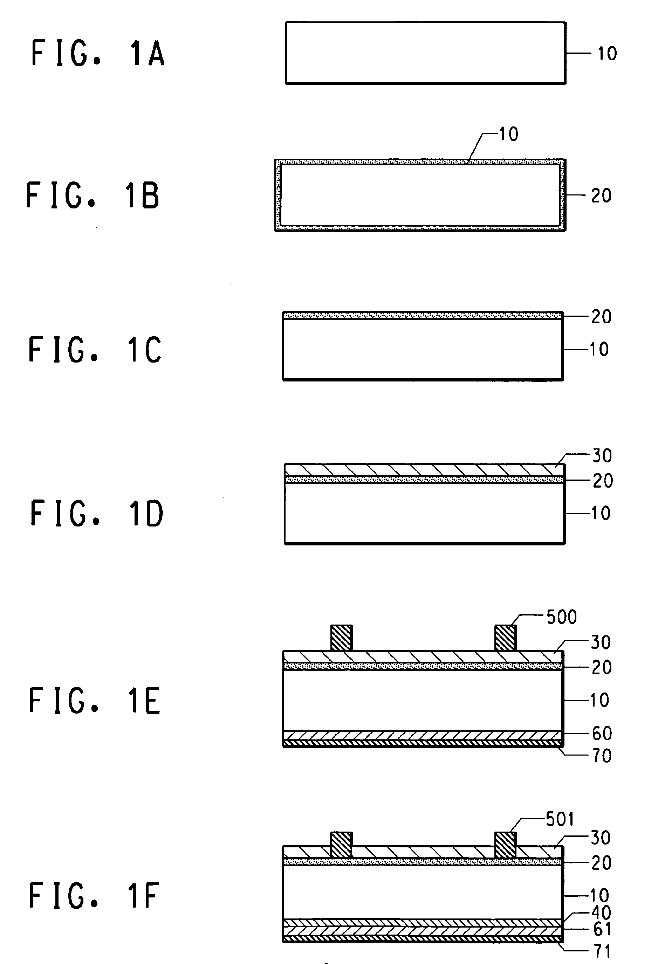

An example of this method of production is described below in conjunction with FIG. 1. FIG. 1A shows a p-type silicon substrate, 10.

In FIG. 1B, an n-type diffusion layer, 20, of the reverse conductivity type is formed by the thermal diffusion of phosphorus (P) or the like. Phosphorus oxychloride (POCl₃) is commonly used as the gaseous phosphorus diffusion source, other liquid sources are phosphoric acid and the like. In the absence of any particular modification, the diffusion layer, 20, is formed over the entire surface of the silicon substrate, 10. The p-n junction is formed where the concentration of the p-type dopant equals the concentration of the n-type dopant; conventional cells that have the p-n junction close to the sun side, have a junction depth between 0.05 and 0.5 µm.

After formation of this diffusion layer excess surface glass is removed from the rest of the surfaces by etching by an acid such as hydrofluoric acid.

Next, an antireflective coating (ARC), 30, is formed on the n-type diffusion layer, 20, to a thickness of between 0.05 and 0.1 µm in the manner shown in FIG. 1D by a process, such as, for example, plasma chemical vapor deposition (CVD).

As shown in FIG. 1E, a front-side silver paste (front electrode-forming silver paste), 500, for the front electrode is screen printed and then dried over the antireflective coating, 30. In addition, a back-side silver or silver/aluminum paste, 70, and an aluminum paste, 60, are then screen printed (or some other application method) and successively dried on the back-side of the substrate. Normally, the back-side silver or silver/aluminum paste is screen printed onto the silicon first as two parallel strips (busbars) or as rectangles (tabs) ready for soldering interconnection strings (presoldered copper ribbons), the aluminum paste is then printed in the bare areas with a slight overlap over the back-side silver or silver/aluminum. In some cases, the silver or silver/aluminum paste is printed after the aluminum paste has been printed. Firing is then typically carried out in a belt furnace for a period of 1 to 5 minutes with the wafer reaching a peak temperature in the range of 700 to 900°C. The front and back electrodes can be fired sequentially or cofired.

Consequently, as shown in FIG. 1F, molten aluminum from the paste dissolves the silicon during the firing process and then on cooling forms a eutectic layer that epitaxially grows from the silicon base, 10, forming a p+ layer, 40, containing a high concentration of aluminum dopant. This layer is generally called the back surface field (BSF) layer, and helps to improve the energy conversion efficiency of the solar cell. A thin layer of aluminum is generally present at the surface of this epitaxial layer.

The aluminum paste is transformed by firing from a dried state, 60, to an aluminum back electrode, 61. The back-side silver or silver/aluminum paste, 70, is fired at the same time, becoming a silver or silver/aluminum back electrode, 71. During firing, the boundary between the back-side aluminum and the back-side silver or silver/aluminum assumes an alloy state, and is connected electrically as well. The aluminum electrode accounts for most areas of the back electrode, owing in part to the need to form a p+ layer, 40. Since soldering to an aluminum electrode is impossible, a silver or silver/aluminum back electrode is formed over portions of the back-side (often as 2 to 6 mm wide busbars) as an electrode for interconnecting solar cells by means of pre-soldered copper ribbon or the like. In addition, the front-side silver paste, 500, sinters and penetrates through the antireflective coating, 30, during firing, and is thereby able to electrically contact the n-type layer, 20. This type of process is generally called "firing through". This fired through state is apparent in layer 501 of FIG. 1F.

A problem associated with the aluminum paste is dusting and transfer of free aluminum or alumina dust to other metallic surfaces, thereby reducing the solderability and adhesion of ribbons tabbed to said surface. This is particularly relevant when the firing process is performed with stacked solar cells.

US-A-2007/0079868 discloses aluminum thick film compositions which can be used in forming aluminum back electrodes of silicon solar cells. Apart from aluminum powder, an organic medium as vehicle and glass frit as an optional constituent the aluminum thick film compositions comprise amorphous silicon dioxide as an essential constituent. The amorphous silicon dioxide serves in particular to reduce the bowing behavior of the silicon solar cells.

EP 1 087 646 discloses aluminum pastes comprising zinc-silicate glass frit in an organic medium.

EP 1 713 092 discloses conductive thick film compositions comprising silver pastes with zinc resinate additives.

It has now been found that aluminum thick film compositions having a similar or even better performance can be obtained when the aluminum thick film compositions disclosed in US-A-2007/0079868 comprise certain zinc-organic components instead of or in addition to the amorphous silicon dioxide. The aluminum dusting problem described above can be minimized or even be eliminated with the novel aluminum thick film compositions. Use of said novel aluminum thick film compositions in the production of aluminum back electrodes of silicon solar cells results in silicon solar cells exhibiting not only good adhesion of the fired aluminum back surface field to the back-side of the silicon wafer but also improved electrical performance.

### SUMMARY OF THE INVENTION

The present invention relates to aluminum pastes (aluminum thick film compositions) for use in forming p-type aluminum back electrodes of silicon solar cells. It further relates to the process of forming and use of the aluminum pastes in the production of silicon solar cells and the silicon solar cells themselves.

The present invention is directed to aluminum pastes comprising: particulate aluminum, a zinc-organic component, an organic vehicle and, as optional components: amorphous silicon dioxide and one or more glass frit compositions.

The present invention is further directed to a process of forming a silicon solar cell and the silicon solar cell itself which utilizes a silicon wafer having a p-type and an n-type region, and a p-n junction, which comprises applying, in particular, screen-printing an aluminum paste of the present invention on the back-side of the silicon wafer, and firing the printed surface, whereby the wafer reaches a peak temperature in the range of 700 to 900 °C.

### BRIEF DESCRIPTION OF THE FIGURES

Figure 1 is a process flow diagram illustrating exemplary the fabrication of a silicon solar cell.

Reference numerals shown in Figure 1 are explained below.
- 10:: p-type silicon wafer
- 20:: n-type diffusion layer
- 30:: antireflective coating, for example, SiNx, TiOx, SiOx
- 40:: p+ layer (back surface field, BSF)
- 60:: aluminum paste formed on back-side
- 61:: aluminum back electrode (obtained by firing back-side aluminum paste)
- 70:: silver or silver/aluminum paste formed on back-side
- 71:: silver or silver/aluminum back electrode (obtained by firing back-side silver or silver/aluminum paste)
- 500:: silver paste formed on front-side
- 501:: silver front electrode (obtained by firing front-side silver paste)

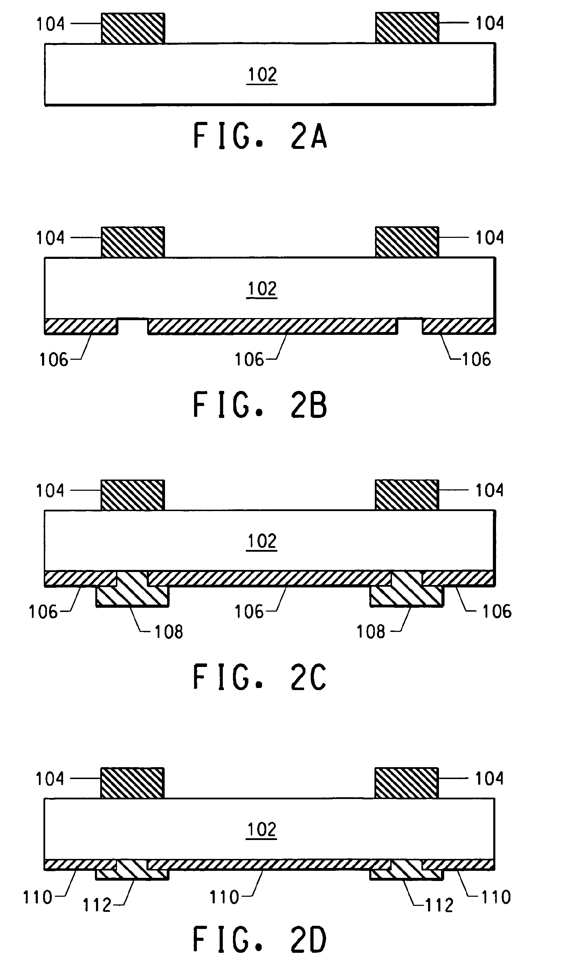

Figures 2 A-D explain the manufacturing process for manufacturing a silicon solar cell using an electroconductive aluminum paste of the present invention. Reference numerals shown in Figure 2 are explained below.
- 102: silicon substrate (silicon wafer)
- 104: light-receiving surface side electrode
- 106: paste composition for a first electrode
- 108: electroconductive paste for a second electrode
- 110: first electrode
- 112: second electrode

### DETAILED DESCRIPTION OF THE INVENTION

The aluminum pastes of the present invention comprise particulate aluminum, a zinc-organic component, an organic vehicle (organic medium) and, in an embodiment, also one or more glass frits.

The particulate aluminum may be comprised of aluminum or an aluminum alloy with one or more other metals like, for example, zinc, tin, silver and magnesium. In case of aluminum alloys the aluminum content is, for example, 99.7 to below 100 wt.%. The particulate aluminum may comprise aluminum particles in various shapes, for example, aluminum flakes, spherical-shaped aluminum powder, nodular-shaped (irregular-shaped) aluminum powder or any combinations thereof. Particulate aluminum, in an embodiment, is in the form of aluminum powder. The aluminum powder exhibits an average particle size (mean particle diameter) determined by means of laser scattering of, for example, 4 to 10 µm. The particulate aluminum may be present in the aluminum pastes of the present invention in a proportion of 50 to 80 wt.%, or, in an embodiment, 70 to 75 wt.%, based on total aluminum paste composition.

In the present description and the claims the term "total aluminum paste composition" is used. It shall mean aluminum paste composition as supplied to the user or customer.

All statements made in the present description and the claims in relation to average particle sizes relate to average particle sizes of the relevant materials as are present in the aluminum paste composition as supplied to the user or customer.

The particulate aluminum present in the aluminum pastes may be accompanied by other particulate metal(s) such as, for example, silver or silver alloy powders. The proportion of such other particulate metal(s) is, for example, 0 to 10 wt.%, based on the total of particulate aluminum plus particulate metal(s).

The aluminum pastes of the present invention comprise a zinc-organic component; in an embodiment, the zinc-organic component may be a liquid zinc-organic component. The term "zinc-organic component" herein refers to solid zinc-organic compounds and liquid zinc-organic components. The term "liquid zinc-organic component" means a solution of one or more zinc-organic compounds in organic solvent(s) or, in an embodiment, one or more liquid zinc-organic compounds themselves.

The zinc-organic component of the aluminum pastes of the present invention, in a non-limiting embodiment, is substantially free of unoxidized zinc metal; in a further embodiment, the zinc-organic component may be greater than 90% free of unoxidized zinc metal; in a further embodiment, the zinc-organic component may be greater than 95%, 97%, or 99% free of unoxidized zinc metal. In an embodiment, the zinc-organic component may be free of unoxidized zinc metal.

In the context of the present invention the term "zinc-organic compound" includes such zinc compounds that comprise at least one organic moiety in the molecule. The zinc-organic compounds are stable or essentially stable, for example, in the presence of atmospheric oxygen or air humidity, under the conditions prevailing during preparation, storage, and application of the aluminum pastes of the present invention. The same is true under the application conditions, in particular, under those conditions prevailing during screen printing of the aluminum pastes onto the back-side of the silicon wafers. However, during firing of the aluminum pastes the organic portion of the zinc-organic compounds will or will essentially be removed, for example, burned and/or carbonized. The zinc-organic compounds as such have a zinc content, in an embodiment, in the range of 15 to 30 wt.%. The zinc-organic compounds may comprise covalent zinc-organic compounds; in particular they comprise zinc-organic salt compounds. Examples of suitable zinc-organic salt compounds include in particular zinc resinates (zinc salts of acidic resins, in particular, resins with carboxyl groups) and zinc carboxylates (zinc carboxylic acid salts). In an embodiment, the zinc-organic compound may be zinc neodecanoate, which is liquid at room temperature. Zinc neodecanoate is commercially available, for example, from Shepherd Chemical Company. In case of liquid zinc-organic compounds such as zinc neodecanoate, the undissolved liquid zinc-organic compound(s) itself/themselves may be used when preparing the aluminum pastes of the present invention; the zinc neodecanoate may form the liquid zinc-organic component.

The zinc-organic component may be present in the aluminum pastes of the present invention in a proportion corresponding to a zinc contribution of 0.05 to 0.6 wt.%, or, in an embodiment, 0.1 to 0.25 wt.%, based on total aluminum paste composition. In case of zinc neodecanoate its proportion in the aluminum pastes may be in the range of 0.5 to 3.0 wt.%, or, in an embodiment, 0.5 to 1.2 wt.%, based on total aluminum paste composition.

In an embodiment, the aluminum pastes of the present invention comprise at least one glass frit composition as an inorganic binder. The glass frit compositions may contain PbO; in an embodiment, the glass frit compositions may be lead free. The glass frit compositions may comprise those which upon firing undergo recrystallization or phase separation and liberate a frit with a separated phase that has a lower softening point than the original softening point.

The (original) softening point (glass transition temperature, determined by differential thermal analysis DTA at a heating rate of 10 K/min) of the glass frit compositions may be in the range of 325 to 600 °C.

The glass frits exhibit average particle sizes (mean particle diameters) determined by means of laser scattering of, for example, 2 to 20 µm. In case of the aluminum pastes comprising glass-frit(s) the glass frit(s) content may be 0.01 to 5 wt.%, or, in an embodiment, 0.1 to 2 wt.%, or, in a further embodiment, 0.2 to 1.25 wt.%, based on total aluminum paste composition.

Some of the glass frits useful in the aluminum pastes are conventional in the art. Some examples include borosilicate and aluminosilicate glasses. Examples further include combinations of oxides, such as: B₂O₃, SiO₂, Al₂O₃, CdO, CaO, BaO, ZnO, Na₂O, Li₂O, PbO, and ZrO₂ which may be used independently or in combination to form glass binders.

The conventional glass frits may be the borosilicate frits, such as lead borosilicate frit, bismuth, cadmium, barium, calcium, or other alkaline earth borosilicate frits. The preparation of such glass frits is well known and consists, for example, in melting together the constituents of the glass in the form of the oxides of the constituents and pouring such molten composition into water to form the frit. The batch ingredients may, of course, be any compounds that will yield the desired oxides under the usual conditions of frit production. For example, boric oxide will be obtained from boric acid, silicon dioxide will be produced from flint, barium oxide will be produced from barium carbonate, etc..

The glass may be milled in a ball mill with water or inert low viscosity, low boiling point organic liquid to reduce the particle size of the frit and to obtain a frit of substantially uniform size. It may then be settled in water or said organic liquid to separate fines and the supernatant fluid containing the fines may be removed. Other methods of classification may be used as well.

The glasses are prepared by conventional glassmaking techniques, by mixing the desired components in the desired proportions and heating the mixture to form a melt. As is well known in the art, heating may be conducted to a peak temperature and for a time such that the melt becomes entirely liquid and homogeneous.

The aluminum pastes of the present invention may comprise amorphous silicon dioxide. The amorphous silicon dioxide is a finely divided powder. In an embodiment, it may have an average particle size (mean particle diameter) determined by means of laser scattering of, for example, 5 to 100 nm. Particularly it comprises synthetically produced silica, for example, pyrogenic silica or silica produced by precipitation. Such silicas are supplied by various producers in a wide variety of types.

In case the aluminum pastes of the present invention comprise amorphous silicon dioxide, the latter may be present in the aluminum pastes in a proportion of, for example, above 0 to 0.5 wt.%, for example, 0.01 to 0.5 wt.%, or, in an embodiment, 0.05 to 0.1 wt.%, based on total aluminum paste composition.

The aluminum pastes of the present invention comprise an organic vehicle. A wide variety of inert viscous materials can be used as organic vehicle. The organic vehicle may be one in which the particulate constituents (particulate aluminum, amorphous silicon dioxide if any, glass frit if any) are dispersible with an adequate degree of stability. The properties, in particular, the rheological properties, of the organic vehicle may be such that they lend good application properties to the aluminum paste composition, including: stable dispersion of insoluble solids, appropriate viscosity and thixotropy for application, in particular, for screen printing, appropriate wettability of the silicon wafer substrate and the paste solids, a good drying rate, and good firing properties. The organic vehicle used in the aluminum pastes of the present invention may be a nonaqueous inert liquid. The organic vehicle may be an organic solvent or an organic solvent mixture; in an embodiment, the organic vehicle may be a solution of organic polymer(s) in organic solvent(s). In an embodiment, the polymer used for this purpose may be ethyl cellulose. Other examples of polymers which may be used alone or in combination include ethylhydroxyethyl cellulose, wood rosin, phenolic resins and poly (meth)acrylates of lower alcohols. Examples of suitable organic solvents comprise ester alcohols and terpenes such as alpha- or beta-terpineol or mixtures thereof with other solvents such as kerosene, dibutylphthalate, diethylene glycol butyl ether, diethylene glycol butyl ether acetate, hexylene glycol and high boiling alcohols. In addition, volatile organic solvents for promoting rapid hardening after application of the aluminum paste on the back-side of the silicon wafer can be included in the organic vehicle. Various combinations of these and other solvents may be formulated to obtain the viscosity and volatility requirements desired.

The organic solvent content in the aluminum pastes of the present invention may be in the range of 5 to 25 wt.%, or, in an embodiment, 10 to 20 wt.%, based on total aluminum paste composition. The number of 5 to 25 wt.% includes a possible organic solvent contribution from a liquid zinc-organic component.

The organic polymer(s) may be present in the organic vehicle in a proportion in the range of 0 to 20 wt.%, or, in an embodiment, 5 to 10 wt.%, based on total aluminum paste composition.

The aluminum pastes of the present invention may comprise one or more organic additives, for example, surfactants, thickeners, rheology modifiers and stabilizers. The organic additive(s) may be part of the organic vehicle. However, it is also possible to add the organic additive(s) separately when preparing the aluminum pastes. The organic additive(s) may be present in the aluminum pastes of the present invention in a total proportion of, for example, 0 to 10 wt.%, based on total aluminum paste composition.

The organic vehicle content in the aluminum pastes of the present invention may be dependent on the method of applying the paste and the kind of organic vehicle used, and it can vary. In an embodiment, it may be from 20 to 45 wt.%, or, in an embodiment, it may be in the range of 22 to 35 wt.%, based on total aluminum paste composition. The number of 20 to 45 wt.% includes organic solvent(s), possible organic polymer(s) and possible organic additive(s).

In an embodiment, aluminum pastes of the present invention comprise
70 to 75 wt.% of particulate aluminum,
zinc-organic component(s) in a proportion corresponding to a zinc contribution of 0.1 to 0.25 wt.%, in particular, 0.5 to 1.2 wt.% zinc neodecanoate,
0.2 to 1.25 wt.% of one or more glass frits,
0 to 0.5 wt.% of amorphous silicon dioxide,
10 to 20 wt.% of one or more organic solvents,
5 to 10 wt.% of one or more organic polymers, and
0 to 5 wt.% of one or more organic additives.

The aluminum pastes of the present invention are viscous compositions, which may be prepared by mechanically mixing the particulate aluminum, the zinc-organic component, the optional glass frit composition(s) and the optional amorphous silicon dioxide with the organic vehicle. In an embodiment, the manufacturing method power mixing, a dispersion technique that is equivalent to the traditional roll milling, may be used; roll milling or other mixing technique can also be used.

The aluminum pastes of the present invention may be used in the manufacture of aluminum back electrodes of silicon solar cells or respectively in the manufacture of silicon solar cells. The manufacture may be performed by applying the aluminum pastes to the back-side of silicon wafers, i.e., to those surface portions thereof which are or will not be covered by other back-side metal pastes like, in particular, back-side silver or silver/aluminum pastes. The silicon wafers may comprise monocrystalline or polycrystalline silicon. In an embodiment, the silicon wafers may have an area of 100 to 250 cm² and a thickness of 180 to 300 µm. However, the aluminum pastes of the present invention can be successfully used even for the production of aluminum back electrodes on the back-side of silicon wafers that are larger and/or having a lower thickness, for example, silicon wafers having a thickness below 180 µm, in particular in the range of 140 to below 180 µm and/or an area in the range of above 250 to 400 cm².

The aluminum pastes are applied to a dry film thickness of, for example, 15 to 60 µm. The method of aluminum paste application may be printing, for example, silicone pad printing or, in an embodiment, screen printing. The application viscosity of the aluminum pastes of the present invention may be 20 to 200 Pa·s when it is measured at a spindle speed of 10 rpm and 25 °C by a utility cup using a Brookfield HBT viscometer and #14 spindle.

After application of the aluminum pastes to the back-side of the silicon wafers they may be dried, for example, for a period of 1 to 100 minutes with the wafers reaching a peak temperature in the range of 100 to 300 °C. Drying can be carried out making use of, for example, belt, rotary or stationary driers, in particular, IR (infrared) belt driers.

After their application or, in an embodiment, after their application and drying, the aluminum pastes of the present invention are fired to form aluminum back electrodes. Firing may be performed, for example, for a period of 1 to 5 minutes with the silicon wafers reaching a peak temperature in the range of 700 to 900 °C. Firing can be carried out making use of, for example, single or multi-zone belt furnaces, in particular, multi-zone IR belt furnaces. Firing happens in the presence of oxygen, in particular, in the presence of air. During firing the organic substance including non-volatile organic material and the organic portion not evaporated during the possible drying step may be removed, i.e. burned and/or carbonized, in particular, burned. The organic substance removed during firing includes organic solvent(s), possible organic polymer(s), possible organic additive(s) and the organic moieties of the one or more zinc-organic compounds. The zinc may remain as zinc oxide after firing. In case the aluminum pastes comprise glass frit(s), there may be a further process taking place during firing, namely sintering of the glass frit(s). Firing may be performed as so-called cofiring together with further metal pastes that have been applied to the silicon wafer, i.e., front-side and/or back-side metal pastes which have been applied to form front-side and/or back-side electrodes on the wafer's surfaces during the firing process. An embodiment includes front-side silver pastes and back-side silver or back-side silver/aluminum pastes.

Next, a non-limiting example in which a silicon solar cell is prepared using an aluminum paste of the present invention is explained, referring to Figure 2.

First, a silicon wafer substrate 102 is prepared. On the light-receiving side face (front-side surface) of the silicon wafer, normally with the p-n junction close to the surface, front-side electrodes (for example, electrodes mainly composed of silver) 104 are installed (Figure 2A). On the back-side of the silicon wafer, a silver or silver/aluminum electroconductive paste (for example, PV202 or PV502 or PV583 or PV581, commercially available from E.I. Du Pont de Nemours and Company) is spread to form either busbars or tabs to enable interconnection with other solar cells set in parallel electrical configuration. On the back-side of the silicon wafer, a novel aluminum paste of the present invention used as a back-side (or p-type contact) electrode for a solar cell, 106 is spread by screen printing using the pattern that enable slight overlap with the silver or silver/aluminum paste referred to above, etc., then dried (Figure 2B). Drying of the pastes is performed, for example, in an IR belt drier for a period of 1 to 10 minutes with the wafer reaching a peak temperature of 100 to 300 °C. Also, the aluminum paste may have a dried film thickness of 15 to 60 µm, and the thickness of the silver or silver/aluminum paste may be 15 to 30 µm. Also, the overlapped part of the aluminum paste and the silver or silver/aluminum paste may be about 0.5 to 2.5 mm.

Next, the substrate obtained is fired, for example, in a belt furnace for a period of 1 to 5 minutes with the wafer reaching a peak temperature of 700 to 900 °C, so that the desired silicon solar cell is obtained (Figure 2D). An electrode 110 is formed from the aluminum paste wherein said paste has been fired to remove the organic substance and, in case the aluminum paste comprises glass frit, to sinter the latter.

The silicon solar cell obtained using the aluminum paste of the present invention, as shown in Figure 2D, has electrodes 104 on the light-receiving face (surface) of the silicon substrate 102, aluminum electrodes 110 mainly composed of aluminum and silver or silver/aluminum electrodes 112 mainly composed of silver or silver and aluminum (formed by firing silver or silver/aluminum paste 108), on the back-side.

### EXAMPLES

The examples cited here relate to thick-film metallization pastes fired onto conventional solar cells that have a silicon nitride anti-reflection coating and front side n-type contact thick film silver conductor.

The present invention can be applied to a broad range of semiconductor devices, although it is especially effective in light-receiving elements such as photodiodes and solar cells. The discussion below describes how a solar cell is formed utilizing the composition(s) of the present invention and how it is tested for its technological properties.

### (1) Manufacture of Solar Cell

A solar cell was formed as follows:
(i) On the back face of a Si substrate (200 µm thick multicrystalline silicon wafer of area 243 cm², p-type (boron) bulk silicon, with an n-type diffused POCl₃ emitter, surface texturized with acid, SiNₓ anti-reflective coating (ARC) on the wafer's emitter applied by CVD) having a 20 µm thick silver electrode on the front surface (PV145 Ag composition commercially available from E. I. Du Pont de Nemours and Company) an Ag/Al paste (PV202, an Ag/Al composition commercially available from E. I. Du Pont de Nemours and Company) was printed and dried as 5 mm wide bus bars. Then, an aluminum paste for the back face electrode of a solar cell was screen-printed at a dried film thickness of 30 µm providing overlap of the aluminum film with the Ag/Al busbar for 1mm at both edges to ensure electrical continuity. The screen-printed aluminum paste was dried before firing.
   The example aluminum pastes comprised 72 wt.% air-atomized aluminium powder (average particle size 6µm), 26 wt.% organic vehicle of polymeric resins and organic solvents, 0.07 wt.% amorphous silica. The example aluminum pastes A to D (according to the invention) comprised zinc neodecanoate additions in the range of 0.7 to 1.5 wt.%, whereas the control example aluminum paste (comparative example) comprised no addition of zinc-organic compounds.
(ii) The printed wafers were then fired in a Centrotherm furnace at a belt speed of 3000 mm/min with zone temperatures defined as zone 1 = 450°C, zone 2 = 520°C, zone 3 = 570°C and the final zone set at 950°C, thus the wafers reaching a peak temperature of 850°C. After firing, the metallized wafer became a functional photovoltaic device.

Measurement of the electrical performance and fired adhesion was undertaken.

### (2) Test Procedures

### Efficiency

The solar cells formed according to the method described above were placed in a commercial I-V tester (supplied by EETS Ltd.) for the purpose of measuring light conversion efficiencies. The lamp in the I-V tester simulated sunlight of a known intensity (approximately 1000 W/m²) and illuminated the emitter of the cell. The metallizations printed onto the fired cells were subsequently contacted by four electrical probes. The photocurrent (Voc, open circuit voltage; Isc, short circuit current) generated by the solar cells was measured over arrange of resistances to calculate the I-V response curve. Fill Factor (FF) and Efficiency (Eff) values were subsequently derived from the I-V response curve.

### Fired Adhesion

In order to measure the cohesive strength of the Al metallizations the amount of material removed from the surface of the fired wafer was determined using a peel test. To this end a transparent layer of adhesive tape was applied and subsequently peeled off. The adhesion figures in Table 1 illustrate an increase in the paste's adhesion as with a corresponding increase in the zinc-organic content of the composition. Peel strength of the example pastes could be further enhanced with the addition of a glass frit.

Examples A to D cited in Table 1 illustrate the electrical properties of the aluminum pastes as a function of zinc-organic content in comparison to the standard composition without the zinc-organic additive (control). The data in Table 1 confirms that the electrical performance of the solar cells made using aluminum pastes according to Examples A to D improves significantly when compared to the solar cell made with the paste according to the control Example. The adhesion of the AI-BSF thick film layer is also shown to improve.

**Table 1**

| Example | wt.% Zn-organic | wt.% glass frit | Voc (mV) | Isc (A) | Eff (%) | FF (%) | Adhesion (%) |
|---|---|---|---|---|---|---|---|
| Control | 0.0 | 0.0 | 606.0 | 6.89 | 11.85 | 68.74 | 15 |
| A | 0.7 | 0.0 | 610.5 | 6.9 | 12.14 | 71.68 | 60 |
| B | 1.2 | 0.0 | 610.5 | 6.94 | 12.47 | 73.95 | 70 |
| C | 1.5 | 0.0 | 607.0 | 6.97 | 12.28 | 70.79 | 80 |
| D | 1.0 | 0.5 | 608.5 | 6.9 | 12.34 | 73.2 | 98 |

## Claims

1. Aluminum pastes comprising particulate aluminum, a zinc-organic component and an organic vehicle comprising organic solvent(s).

2. The aluminum pastes of claim 1 additionally comprising one or more glass frits in a total proportion of 0.01 to 5 wt.%, based on total aluminum paste composition.

3. The aluminum pastes of claim 1 or 2 additionally comprising amorphous silicon dioxide in a proportion of above 0 to 0.5 wt.%, based on total aluminum paste composition.

4. The aluminum pastes of claim 1, 2 or 3, wherein the particulate aluminum is present in a proportion of 50 to 80 wt.%, based on total aluminum paste composition.

5. The aluminum pastes of any one of the preceding claims, wherein the zinc-organic component is selected from the group consisting of one solid zinc-organic compound, a combination of two or more solid zinc-organic compounds, one liquid zinc-organic compound, a combination of two or more liquid zinc-organic compounds, a combination of solid and liquid zinc-organic compounds and a solution of one or more zinc-organic compounds in organic solvent(s).

6. The aluminum pastes of claim 5, wherein the zinc-organic component is present in a proportion corresponding to a zinc contribution of 0.05 to 0.6 wt.%, based on total aluminum paste composition.

7. The aluminum pastes of claim 5, wherein the zinc-organic compound(s) is/are zinc-organic salt compounds selected from the group consisting of zinc resinates and zinc carboxylates.

8. The aluminum pastes of claim 5, wherein the zinc-organic component is zinc neodecanoate being present in a proportion of 0.5 to 3.0 wt.%, based on total aluminum paste composition.

9. The aluminum pastes of any one of the preceding claims, wherein the organic vehicle further comprises organic polymer(s) and/or organic additive(s).

10. A process of forming a silicon solar cell comprising the steps:
(i) applying an aluminum paste of any one of the preceding claims on the back-side of a silicon wafer having a p-type region, an n-type region and a p-n junction, and
(ii) firing the surface provided with the aluminum paste, whereby the wafer reaches a peak temperature of 700 to 900 °C.

11. The process of claim 10, wherein the application of the aluminum paste is performed by printing.

12. The process of claim 10 or 11, wherein firing is performed as cofiring together with other front-side and/or back-side metal pastes that have been applied to the silicon wafer to form front-side and/or back-side electrodes thereon during firing.

13. Silicon solar cells made by the process of any one of claims 10 to 12.

14. A silicon solar cell comprising an aluminum back electrode wherein the aluminum back electrode is produced making use of an aluminum paste of any one of claims 1 to 9.

15. The silicon solar cell of claim 14, further comprising a silicon wafer.

## Patentansprüche

1. Aluminiumpasten umfassend teilchenförmiges Aluminium, eine zinkorganische Komponente und ein organisches Vehikel umfassend organische(s) Lösungsmittel.

2. Aluminiumpasten nach Anspruch 1, zusätzlich eine oder mehrere Glasfritten in einem Gesamtanteil von 0,01 bis 5 Gew.-%, auf die gesamte Aluminiumpastenzusammensetzung bezogen, umfassend.

3. Aluminiumpasten nach Anspruch 1 oder 2, zusätzlich amorphes Siliciumdioxid in einem Anteil von mehr als 0 bis 0,5 Gew.-%, auf die gesamte Aluminiumpastenzusammensetzung bezogen, umfassend.

4. Aluminiumpasten nach Anspruch 1, 2 oder 3, wobei das teilchenförmige Aluminium in einem Anteil von 50 bis 80 Gew.-%, auf die gesamte Aluminiumpastenzusammensetzung bezogen, vorliegt.

5. Aluminiumpasten nach einem der vorhergehenden Ansprüche, wobei die zinkorganische Komponente aus der Gruppe ausgewählt ist bestehend aus einer festen zinkorganischen Verbindung, einer Kombination von zwei oder mehreren festen zinkorganischen Verbindungen, einer flüssigen zinkorganischen Verbindung, einer Kombination von zwei oder mehreren flüssigen zinkorganischen Verbindungen, einer Kombination von festen und flüssigen zinkorganischen Verbindungen und einer Lösung von einer oder mehreren zinkorganischen Verbindungen in organischem Lösungsmittel /organischen Lösungsmitteln.

6. Aluminiumpasten nach Anspruch 5, wobei die zinkorganische Komponente in einem Anteil vorliegt, der einem Zinkbeitrag von 0,05 bis 0,6 Gew.-%, auf die gesamte Aluminiumpastenzusammensetzung bezogen, entspricht.

7. Aluminiumpasten nach Anspruch 5, wobei die zinkorganische(n) Verbindung(en) zinkörganische Salzverbindungen ausgewählt aus der Gruppe bestehend aus Zinkresinaten und Zinkcarboxylaten ist/sind.

8. Aluminiumpasten nach Anspruch 5, wobei die zinkorganische Komponente Zinkneodecanoat ist, das in einem Anteil von 0,5 bis 3,0 Gew.-%, auf die gesamte Aluminiumpastenzusammensetzung bezogen, vorliegt.

9. Aluminiumpasten nach einem der vorhergehenden Ansprüche, wobei das organische Vehikel des Weiteren organische(s) Polymer(e) und/oder organische(s) Zusatzmittel umfasst.

10. Verfahren zum Bilden einer Siliciumsolarzelle, umfassend die Schritte:
(i) Aufbringen einer Aluminiumpaste nach einem der vorhergehenden Ansprüche auf die Rückseite eines Siliciumwafers, der eine p-Typ-Region, eine n-Typ-Region und einen p-n-Übergang aufweist und
(ii) Brennen der mit der Aluminiumpaste versehenen Oberfläche, wobei der Wafer eine Spitzentemperatur von 700 bis 900 °C erreicht.

11. Verfahren nach Anspruch 10, wobei das Aufbringen der Aluminiumpaste durch Drucken erfolgt.

12. Verfahren nach Anspruch 10 oder 11, wobei das Brennen als gleichzeitiges Brennen zusammen mit anderen Vorderseiten- und/oder Rückseitenmetallpasten durchgeführt wird, die auf den Siliciumwafer aufgebracht worden sind, um während des Brennens Vorderseiten- und/oder Rückseitenelektroden darauf zu bilden.

13. Siliciumsolarzellen, die durch das Verfahren nach einem der Ansprüche 10 bis 12 hergestellt werden.

14. Siliciumsolarzelle umfassend eine rückseitige Aluminiumelektrode, wobei die rückseitige Aluminiumelektrode unter Anwendung einer Aluminiumpaste nach einem der Ansprüche 1 bis 9 hergestellt wird.

15. Siliciumsolarzelle nach Anspruch 14, des Weitem einen Siliciumwafer umfassend.

## Revendications

1. Pâtes d'aluminium comprenant de l'aluminium sous forme de particules, un composant organique de zinc et un véhicule organique comprenant un(des) solvant(s) organique(s).

2. Pâtes d'aluminium selon la revendication 1, comprenant additionnellement une ou plusieurs fritte(s) de verre en une proportion totale de 0,01 à 5 % en pds, basée sur la composition totale de pâte d'aluminium.

3. Pâtes d'aluminium selon la revendication 1 ou 2, comprenant additionnellement du dioxyde de silicium amorphe en une proportion située au-dessus de 0 à 0,5 % en pds, basée sur la composition totale de pâte d'aluminium.

4. Pâtes d'aluminium selon la revendication 1, 2 ou 3, l'aluminium sous forme de particule étant présent en une proportion de 50 à 80 % en pds, basée sur la composition totale de pâte d'aluminium.

5. Pâtes d'aluminium selon l'une quelconque des revendications précédentes, le composant organique de zinc étant choisi parmi le groupe constitué d'un composé organique de zinc solide, d'une combinaison de deux composés organiques de zinc solides ou plus, d'un composé organique de zinc liquide, d'une combinaison de deux composés organiques de zinc liquides ou plus, d'une combinaison de composés organiques de zinc solides et liquides et d'une solution d'un composé organique de zinc ou plus dans un(des) solvant(s) organique(s).

6. Pâtes d'aluminium selon la revendication 5, le composant organique de zinc étant présent en une proportion correspondant à une contribution du zinc de 0,05 à 0,6 % en pds, basée sur la composition totale de pâte d'aluminium.

7. Pâtes d'aluminium selon la revendication 5, dans lesquelles le(s) composant(s) organique(s) de zinc est/sont des composés de sel organique de zinc choisis parmi le groupe constitué des résinates de zinc et des carboxylates de zinc.

8. Pâtes d'aluminium selon la revendication 5, dans lesquelles le composant organique de zinc est du néodécanoate de zinc étant présent en une proportion de 0,5 à 3,0 % en pds, basée sur la composition totale de pâte d'aluminium.

9. Pâtes d'aluminium selon l'une quelconque des revendications précédentes, le véhicule organique comprenant en outre un(des) polymère(s) et/ou un(des) additif(s) organique(s).

10. Procédé de formation d'une pile solaire en silicium comprenant les étapes:
(i) d'application d'une pâte d'aluminium selon l'une quelconque des revendications précédentes sur la face arrière d'une galette en silicium ayant une région de type p, une région de type n et une jonction p-n, et
(ii) la cuisson de la surface dotée de la pâte d'aluminium, la galette atteignant une température pic de 700 à 900°C.

11. Procédé selon la revendication 10, dans lequel l'application de la pâte d'aluminium est effectuée par impression.

12. Procédé selon la revendication 10 ou 11, dans lequel la cuisson est effectuée par cocuisson conjointement avec les autres pâtes métalliques de face avant et/ou de face arrière qui ont été appliquées à la galette de silicium pour y former des électrodes en face avant et/ou en face arrière durant la cuisson.

13. Piles solaires en silicium fabriquées selon le procédé selon l'une quelconque des revendications 10 à 12.

14. Pile solaire en silicium comprenant une électrode de face arrière en aluminium, l'électrode de face arrière en aluminium étant produite en utilisant une pâte d'aluminium selon l'une quelconque des revendications 1 à 9.

15. Pile solaire en silicium selon la revendication 14, comprenant en outre une galette de silicium.
